Europäisches Patentamt

European Patent Office

Office européen des brevets

(19)

(11) Veröffentlichungsnummer : **0 285 831 B1**

(12) # EUROPÄISCHE PATENTSCHRIFT

(45) Veröffentlichungstag der Patentschrift :
**05.06.91 Patentblatt 91/23**

(51) Int. Cl.$^5$ : **H05K 1/00**

(21) Anmeldenummer : **88103631.3**

(22) Anmeldetag : **08.03.88**

(54) **Rückwandleiterplatte.**

(30) Priorität : **20.03.87 DE 3709113**

(43) Veröffentlichungstag der Anmeldung :
**12.10.88 Patentblatt 88/41**

(45) Bekanntmachung des Hinweises auf die
Patenterteilung :
**05.06.91 Patentblatt 91/23**

(84) Benannte Vertragsstaaten :
**CH DE FR GB LI**

(56) Entgegenhaltungen :
**EP-A- 0 004 899
EP-A- 0 195 955
DE-A- 2 233 578**

(56) Entgegenhaltungen :
**DE-U- 8 410 261
FR-A- 2 525 065
GB-A- 1 523 136
JEE, JOURNAL OF ELECTRONIC ENGINEE-
RING, Band 17, Nr. 157, Januar 1980, Seiten
30,31, Tokyo, JP; Y. GOTO: "DIP switches
achieve high density switching"**

(73) Patentinhaber : **Siemens Aktiengesellschaft
Wittelsbacherplatz 2
W-8000 München 2 (DE)**

(72) Erfinder : **Brune, Johannes, Dipl.-Ing.
Am Deckesweiher 4
W-8520 Erlangen (DE)**
Erfinder : **Latussek, Hans-Peter, Dipl.-Ing.
Heideweg 77
W-8501 Feucht (DE)**

EP 0 285 831 B1

## Beschreibung

Die Erfindung bezieht sich auf eine Rückwandleiterplatte mit mehreren parallel nebeneinander auf der den Baugruppen zugewandten Seite angeordneten Federleisten und mit wenigstens einem Bus, der wenigstens aus einer Busleitung besteht.

Derartige Rückwandleiterplatten sind im Handel erhältlich und beispielsweise als VME-Bus-Leiterplatte bekannt. Dabei ist der VME-Bus ein standardisierter Bus, der für den grundlegenden schnellen Datenverkehr zwischen den wichtigsten Komponenten eines Bussystemes zuständig ist. Dabei bildet die Busstruktur die Verbindungsschienen zwischen den Bausteinen und -gruppen eines Mikro- oder Minicomputersystems. Je nach den verwendeten Systemkomponenten und der geforderten Leistungsfähigkeit variieren auch die Busstrukturen. Da der gesamte Datenaustausch über derartige Bussysteme erfolgt, beeinflußt deren Struktur die Leistungsfähigkeit des Gesamtsystems. Der Datenaustausch erfolgt beispielsweise im 8-, 16- oder 32-Bit-Format, d.h., es sind beispielsweise 8, 16 oder 32 Busleitungssysteme vorgesehen, die die einzelnen Baugruppen eines Bussystems untereinander verbinden. Bei derartigen baugruppenübergreifenden Systemen kann ein Fehler, beispielsweise ein Kurzschluß eines Ausgangstreibers mit der Versorgungsspannung eines Busteilnehmers, das gesamte Bussystem blockieren. Eine Lokalisierung des defekten Busteilnehmers ist bei vielen Fehlerarten mit Hilfe einer Diagnoseroutine möglich. Jedoch kann bei einigen Fehlerarten die Störung nur dadurch gefunden werden, daß nacheinander alle Busteilnehmer vom Bus getrennt werden bis der defekte Teilnehmer gefunden und damit die Störung behoben ist. Beim Herausziehen des Busteilnehmers aus seinem Steckplatz in einem Baugruppenträger wird die gesamte Funktion des betroffenen Teilnehmers außer Betrieb gesetzt. Dies bringt erhebliche Einschränkungen der Verfügbarkeit mit sich.

Der Erfindung liegt nun die Aufgabe zugrunde, eine Rückwandleiterplatte der eingangs genannten Art so weiterzubilden, daß mindestens eine Baugruppe von einem baugruppenübergreifenden Bus abgetrennt werden kann, ohne dabei die Baugruppe selbst aus ihrem Steckplatz eines Baugruppenträgers herausziehen zu müssen.

Diese Aufgabe wird erfindungsgemäß dadurch gelöst, daß einem Buskontaktstift jeder Federleiste eines Busses ein mit zwei kontaktstiften versehener federnder Kontakt zugeordnet ist, wobei die federnden Kontakte auf der den Baugruppen abgewandten Seite der Rückwandleiterplatte angebracht sind, wobei jeweils der den Buskontaktstift jeder Federleiste benachbarte Kontaktstift des federnden Kontaktes elektrisch leitend mit dem zugeordneten Buskontaktstift verbunden ist, daß der zweite Kontaktstift jedes federnden Kontaktes mittels der Busleitung miteinander elektrisch leitend verbunden sind und daß die Kontaktierung jedes federnden Kontaktes mittels eines Handhabungsmittels steuerbar ist.

Gegenüber der bekannten Rückwandleiterplatte verbinden die Busleitungen eines Busses nicht jeweils die Buskontaktstifte mehrerer Federleisten miteinander, sondern jeweils die zweiten Kontaktstifte jedes federnden Kontaktes miteinander. Dabei ist jeweils der erste Kontaktstift dieser federnden Kontakte elektrisch leitend mit den korrespondierenden Buskontaktstiften der Federleisten verbunden. Die Kontaktierung ist mittels eines Handhabungsmittels steuerbar. Somit ist es möglich, Baugruppen, auf denen ein Fehler derartig aufgetreten ist, daß der baugruppenübergreifende Bus gestört wird, von diesem Bus zu trennen, ohne dabei die Baugruppe aus dem Baugruppenträger herausziehen zu müssen. Denn mit dem Herausziehen der fehlerbehafteten Baugruppe werden auch sämtliche andere Funktionen dieser Baugruppe außer Betrieb gesetzt.

Als Handhabungsmittel sind Stifte aus Isoliermaterial vorgesehen, deren Kontaktbereiche elektrisch leitend sind. Diese Stifte werden jeweils zwischen den beiden Kontaktstiften der federnden federnden Kontakte gesteckt, wodurch jeweils der Buskontaktstift der Federleisten mit einer Busleitung elektrisch leitend verbunden wird. Somit kann man die Kontaktierung jedes federnden Kontaktes durch Einstecken oder Herausziehen des Handhabungsmittels steuern, wodurch die Buskontakte einer jeden Federleiste mit den Busleitern eines Busses elektrisch leitend verbunden oder getrennt werden können.

In einer vorteilhaften Ausführungsform der federnden Kontakte werden jeweils die Kontaktstifte der federnden Kontakte mittels ihrer Federkraft elektrisch leitend miteinander verbunden. Dadurch benötigt man nur noch ein Handhabungsmittel zum Auftrennen der Kontaktstifte. D.h. man benötigt bei einer fehlerbehafteten Baugruppe im baugruppenübergreifenden Bussystem nur ein Handhabungsmittel. Dadurch kann man bei der Fehlerortung mit ein und demselben Handhabungsmittel nacheinander alle im Bussystem vorhandenen Baugruppen vom Bus trennen, ohne dabei die Baugruppen aus dem Baugruppenträger herausziehen zu müssen.

Zur weiteren Erläuterung der Erfindung wird auf die Zeichnung Bezug genommen, in der Ausführungsbeispiele nach der Erfindung schematisch veranschaulicht sind.

FIG 1 zeigt einen Längsschnitt durch eine Rückwandleiterplatte, die mit zwei Bussen versehen ist, die

FIG 2 veranschaulicht eine Draufsicht auf der den Baugruppen abgewandten Seite der Rückwandleiterplatte nach einem Schnitt II-II nach FIG 1 und die

FIG 3 zeigt eine weitere Ausführungsform einer Rückwandleiterplatte nach der Erfindung.

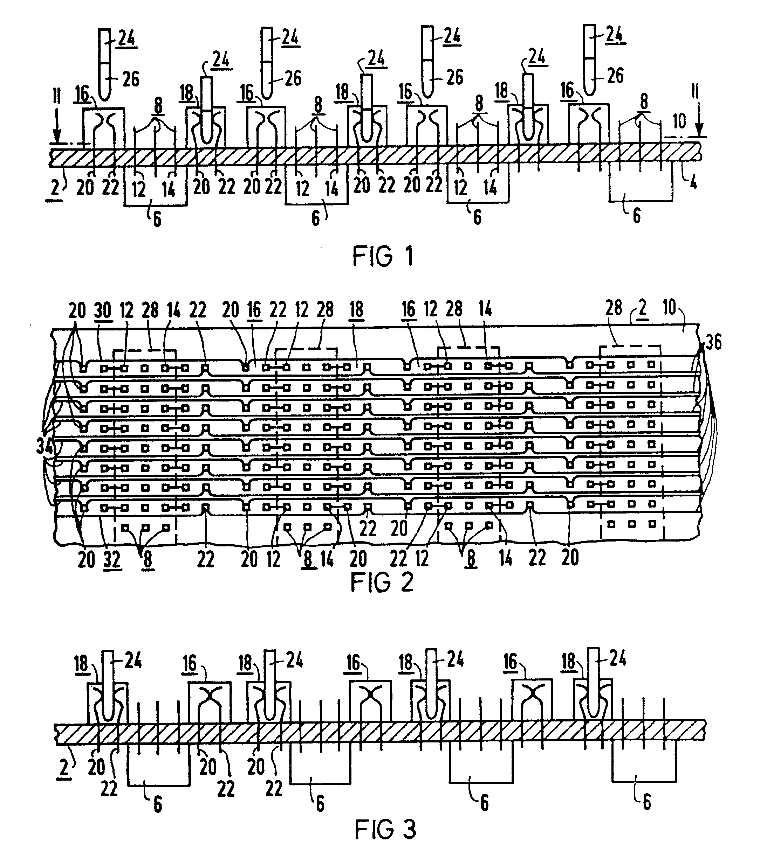

Die FIG 1 zeigt einen Längsschnitt durch eine Rückwandleiterplatte 2, die auf der den Baugruppen zugewandten Seite 4 mit mehreren Federleisten 6 versehen ist. Die Kontaktstifte 8 der Federleisten 6 bilden auf der den Baugruppen abgewandten Seite 10 ein Stachelfeld. Jedem Buskontaktstift 12 bzw. 14 ist ein federnder Kontakt 16 bzw. 18 zugeordnet. Diese federnden Kontakte 16 bzw. 18 sind auf der den Baugruppen abgewandten Seite 10 der Rückwandleiterplatte 2 angeordnet. Jeder federnde Kontakt 16 bzw. 18 enthält zwei Kontaktstifte 20 und 22, die mittels eines Handhabungsmittels 24 elektrisch leitend verbunden sind. Als Handhabungsmittel 24 kann ein Stift aus Isoliermaterial vorgesehen sein, wobei der Kontaktbereich 26 mit einer leitenden Schicht versehen ist. In den federnden Kontaktstifte 18 sind jeweils die Handhabungsmittels 24 gesteckt, wodurch jeweils die Kontakte 20 und 22 elektrisch leitend verbunden sind.

Die FIG 2 zeigt eine Draufsicht auf der den Baugruppen abgewandten Seite 10 der Rückwandleiterplatte 2 gemäß einem Schnitt II-II nach FIG 1. Die Federleiste 6, die auf der den Baugruppen zugewandten Seite 4 der Rückwandleiterplatte 2 angeordnet sind, sind auf der den Baugruppen abgewandten Seite 10 der Rückwandleiterplatte 2 jeweils mittels einer unterbrochenen Linie 28 dargestellt. Als Federleisten 6 sind beispielsweise 96-polige Federleisten vorgesehen, wobei die Kontakte 8 jeweils in drei Kontaktreihen angeordnet sind. Außerdem sind zwei Busse 30 und 32 vorgesehen, die jeweils acht Busleitungen 34 bzw. 36 haben. Dabei ist der Bus 32 redundant zum Bus 30. Die Buskontaktstifte 12 jeder Federleiste 6 des Busses 30 gehören zu den Kontaktstiften 8 einer äußeren Kontaktstiftreihe jeder Federleiste 6. Jedem dieser Buskontaktstifte 12 ist ein federnder Kontakt 16 zugeordnet, wobei jeweils der Kontaktstift 22 direkt mit dem Buskontaktstift 12 elektrisch leitend verbunden ist. Die acht Kontaktstifte 20 der federnden Kontakte 16 sind mit den acht Busleitungen 34 des Busses 30 elektrisch leitend verbunden. Den Buskontaktstiften 14, die jeweils zu den Kontakten 8 einer äußeren Kontaktstiftreihe einer jeden Federleiste 6 gehören, sind jeweils federnde Kontakte 18 zugeordnet. Die Kontaktstifte 20 dieser federnden Kontakte 18 sind jeweils elektrisch leitend mit den korrespondierenden Buskontaktstiften 14 verbunden, wogegen die acht Kontaktstifte 22 mit den acht Busleitungen 36 des Busses 32 elektrisch leitend verbunden sind. Wie die FIG 1 zeigt, sind in die federnden Kontakte 18 die Handhabungsmittel 24 gesteckt. Als Handhabungsmittel 24 kann eine Isolierplatte mit einem leitenden Bereich vorgesehen sein, deren Länge dem Busformat, beispielsweise 8, 16 oder 32 Busleitungen, entspricht.

Im betriebsgemäßen Zustand der Rückwandleiterplatte 2 sind alle Busteilnehmer-Baugruppen mittels der Handhabungsmittel 24 an den beiden Bussen 30 und 32 angeschlossen, wobei der Datentransfer zwischen den einzelnen Busteilnehmer-Baugruppen auf dem Bus 30 stattfindet. Wenn nun ein Fehler auftritt, der diesen Bus 30 stört, kann auf den Bus 32 umgeschaltet werden, da beide Busse 30 und 32 redundant sind. Dadurch kann das System in Betrieb bleiben. Die Fehlersuche erfolgt auf dem gestörten Bus 30 durch das Trennen der Baugruppen vom Bus 30, d.h. nacheinander werden die Handhabungsmittel 24 aus den federnden Kontakten 16 gezogen und wieder hineingesteckt. In Verbindung mit einer geeigneten Testroutine wird festgestellt, wann die Blockierung des Busses 30 behoben ist. Die so lokalisierte defekte Busteilnehmer-Baugruppe kann nun ausgetauscht werden. Durch diese indirekte Ankopplung der Busteilnehmer-Baugruppen an die baugruppenübergreifenden Busse 30 und 32 können jederzeit die einzelnen Baugruppen von den Bussen 30 und 32 getrennt werden, ohne dabei die Baugruppe aus ihrem Steckplätzen eines Baugruppenträgers herausziehen zu müssen. Dadurch bleiben die zusätzlichen Funktionen dieser Baugruppe in Betrieb, wodurch die Verfügbarkeit des Systems vergrößert wird.

Die Darstellung der Rückwandleiterplatte 2 nach FIG 3 entspricht im wesentlichen der Darstellung der Rückwandleiterplatte 2 nach FIG 1. Als federnder Kontakt 16 bzw. 18 ist jeweils ein geschlossener Kontakt vorgesehen. Bei diesen geschlossenen Kontakten erfolgt jeweils die Kontaktierung der Kontaktstifte 20 und 22 mittels ihrer Federkräfte. Auch bei diesen federnden Kontakten 16 bzw. 18 kann man mit Hilfe eines Handhabungsmittels 24 jeweils die Kontaktierung ihrer Kontaktstifte 20 und 22 steuern. Als Handhabungsmittel 24 kann ein Isolierstift oder entsprechend des Busformates auch Isolierplatten vorgesehen sein. Bei dieser Ausführung benötigt man wenigstens nur ein Handhabungsmittels 24, wenn eine Busteilnehmer-Busbaugruppe fehlerbehaftet ist und den Bus 30 bzw. 32 blockiert. Gemäß der Ausführungsform nach FIG 1 benötigt man für jede Baugruppe des Bussystems zwei Handhabungsmittel 24, damit die Rückwandleiterplatte 2 betriebsbereit ist. Dadurch ist bei der Ausführungsform nach FIG 3 die Rückwandleiterplatte 2 ohne ein Handhabungsmittel 24 betriebsbereit. Außerdem erleichtert sich die Fehlerortung, da im einfachsten Fall nur ein Handhabungsmittel 24 nacheinander in die geschlossenen Kontakte des blockierten Busses 30 bzw. 32 gesteckt werden müssen.

## Ansprüche

1. Rückwandleiterplatte (2) mit mehreren parallel nebeneinander auf der den Baugruppen zugewandten Seite (4) angeordneten Federleisten (6) und mit wenigstens einem Bus (30, 32), der wenigstens aus einer Busleitung (34, 36) besteht, **dadurch gekenn-**

zeichnet, daß einem Buskontaktstift (12, 14) jeder Federleiste (6) eines Busses (30, 32) ein mit zwei kontaktstiften versehener federnder Kontakt (16, 18) zugeordnet ist, wobei die federnden Kontakte (16, 18) auf der den Baugruppen abgewandten Seite (10) der Rückwandleiterplatte (2) angebracht sind, wobei jeweils der dem Buskontaktstift (12, 14) jeder Federleiste (6) benachbarte Kontaktstift (22, 20) des federnden Kontaktes (16, 18) elektrisch leitend mit dem zugeordneten Buskontaktstift (12, 14) verbunden ist, daß der zweite Kontaktstift (20, 22) jedes federnden Kontaktes (16, 18) mittels der Busleitung (34, 36) miteinander elektrisch leitend verbunden sind und daß die Kontaktierung jedes federnden Kontaktes (16, 18) mittels eines Handhabungsmittels (24) steuerbar ist.

2. Rückwandleiterplatte (2) nach Anspruch 1, **dadurch gekennzeichnet**, daß als Handhabungsmittel (24) ein Stift aus Isoliermaterial vorgesehen ist, dessen Kontaktbereich (26) elektrisch leitend ist.

3. Rückwandleiterplatte (2) nach Anspruch 1, **dadurch gekennzeichnet**, daß die Kontaktstifte (20, 22) des federnden Kontaktes (16, 18) mittels ihrer Federkraft miteinander elektrisch verbunden sind.

4. Rückwandleiterplatte (2) nach Anspruch 1 und 3, **dadurch gekennzeichnet**, daß als Handhabungsmittel (24) ein Isolierstift vorgesehen ist.

5. Rückwandleiterplatte (2) nach Anspruch 1 mit wenigstens zwei Bussen (30, 32), die jeweils aus mehreren Busleitungen (34, 36) bestehen, **dadurch gekennzeichnet**, daß als Handhabungsmittel (24) eine Isolierplatte vorgesehen ist, die im Kontaktbereich (26) mit einer leitenden Schicht versehen ist.

## Claims

1. A backplane printed circuit board (2) with several socket connectors (6) arranged parallel to one another, side by side on the side (4) that faces the modules, and with at least one bus (30, 32) consisting of at least one bus line (34, 36), characterised in that a resilient contact (16, 18) provided with two contact pins is allocated to a bus contact pin (12, 14) of each socket connector (6) of a bus (30, 32), wherein the resilient contacts (16, 18), are attached to the side (10) of the backplane printed circuit board (2) facing away from the modules, wherein in each case the contact pin (22, 20) of the resilient contact (16, 18) adjacent to the bus contact pin (12, 14) of each socket connector (6) is connected in an electrically conducting manner to the associated bus contact pin (12, 14), in that the second contact pins (20, 22) of each resilient contact (16, 18) are connected to each other in an electrically conducting manner by means of the bus line (34, 36) and in that the contact of each resilient contact (16, 18) is able to be controlled by means of a handling means (24).

2. A backplane printed circuit board (2) according to claim 1, characterised in that as handling means (24) there is provided a pin of insulating material, the contact region (26) of which is electrically conductive.

3. A backplane printed circuit board (2) according to claim 1, characterised in that the contact pins (20, 22) of the resilient contact (16, 18) are connected electrically to each other by means of their spring force.

4. A backplane printed circuit board (2) according to claim 1 and 3, characterised in that an insulating pin is provided as handling means (24).

5. A backplane printed circuit board (2) according to claim 1 with at least two buses (30, 32), which consist of several bus lines (34, 36), characterised in that as handling means (24) an insulating plate is provided, which is provided in the contact region (26) with a conductive layer.

## Revendications

1. Plaquette à circuits imprimés de paroi arrière (2) comportant plusieurs barrettes à ressorts (6) parallèles, disposées côte-à-côte, sur la face (4) tournée vers les modules, et comportant au moins un bus (30, 32) constitué au moins par un conducteur de bus (34, 36), caractérisée par le fait qu'à une broche de contact de bus (12, 14) de chaque barrette à ressort (6) d'un bus (30, 32) est associé un contact élastique (16, 18) comportant deux broches de contact, que les contacts élastiques (16, 18) sont disposés sur la face (10), tournée à l'opposé des modules, de la plaquette à circuits imprimés de paroi arrière (2), que respectivement la broche de contact (22, 20), qui est voisine de la broche de contact de bus (12, 14) de chaque barrette à ressort (6), du contact élastique (16, 18) est raccordée selon une liaison électriquement conductrice à la broche associée de contact de bus (12, 14), que les secondes broches de contact (20, 22) des contacts élastiques respectifs (16, 18) sont raccordées entre elles d'une manière électriquement conductrice au moyen du conducteur formant bus (34, 36) et que la liaison de contact avec chaque contact élastique (16, 18) peut être commandée à l'aide d'un dispositif de manipulation (24).

2. Plaquette à circuits imprimés de paroi arrière (2) suivant la revendication 1, caractérisée par le fait qu'il est prévu, comme dispositif de manipulation (24), une broche réalisée en un matériau isolant et dont la zone de contact (26) est électriquement conductrice.

3. Plaquette à circuits imprimés de paroi arrière (2) suivant la revendication 1, caractérisée par le fait que les broches de contact (20, 22) du contact élastique (16, 18) sont raccordées entre elles d'une manière électriquement conductrice sous l'effet de leur force élastique.

4. Plaquette à circuits imprimés de paroi arrière (2) suivant les revendications 1 et 3, caractérisée par le fait qu'il est prévu une tige isolante comme dispositif de manipulation (24).

5. Plaquette à circuits imprimés de paroi arrière (2) suivant la revendication 1, comportant au moins deux bus (30, 32), qui sont constitués chacun par plusieurs conducteurs de bus (34, 36), caractérisée par le fait qu'il est prévu, comme dispositif de manipulation (24), une plaque isolante qui comporte une couche conductrice, dans la zone de contact (26).

FIG 1

FIG 2

FIG 3